**Europäisches Patentamt**

**European Patent Office**

**Office européen des brevets**

(19)

(11) Veröffentlichungsnummer : **0 092 653**
**B1**

(12) **EUROPÄISCHE PATENTSCHRIFT**

(45) Veröffentlichungstag der Patentschrift :
26.03.86

(51) Int. Cl.⁴ : **H 01 F 40/14**

(21) Anmeldenummer : **83101496.4**

(22) Anmeldetag : **17.02.83**

(54) **Messwandler für Messgeräte.**

(30) Priorität : **22.04.82 CH 2438/82**

(43) Veröffentlichungstag der Anmeldung :
**02.11.83 Patentblatt 83/44**

(45) Bekanntmachung des Hinweises auf die Patenterteilung : **26.03.86 Patentblatt 86/13**

(84) Benannte Vertragsstaaten :
**AT FR GB NL SE**

(56) Entgegenhaltungen :
**AT-B-    129 185**
**CH-A-    284 484**
**CH-A-    414 841**
**WALTER, 1944: Strom- und Spannungswandler, S 16**

(73) Patentinhaber : **LGZ LANDIS & GYR ZUG AG**

**CH-6301 Zug (CH)**

(72) Erfinder : **Halder, Mathis**
**Untere Rainstrasse 18**
**CH-6340 Baar (CH)**

(74) Vertreter : **Müller, Hans-Jürgen, Dipl.-Ing. et al**
**Müller, Schupfner & Gauger Lucile-Grahn-Strasse 38**
**Postfach 80 13 69**
**D-8000 München 80 (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung bezieht sich auf eine Meßwandleranordnung mit zwei Magnetkernen zur Messung von elektrischen Wechselströmen.

Derartige Meßwandler für Meßgeräte zur Messung von elektrischen Strömen sind bereits bekannt (Walter : Strom- und Spannungswandler, 1944, Seite 16). Sie bestehen aus Magnetkernen mit einer Primärwicklung, welche den zu messenden Strom führt, und einer Sekundärwicklung, die einen dem Meßgerät angepaßten Strom führt. Das Verhältnis der Windungszahlen von Primär- und Sekundärwicklung bestimmt das Übersetzungsverhältnis ü des Meßwandlers. Ein großes Übersetzungsverhältnis ü bedingt eine hohe Windungszahl der Sekundärwicklung. So benötigt zum Beispiel ein Meßwandler mit primärseitig 10 A und sekundärseitig 100 mA eine Sekundärwicklung mit 100 Windungen, wenn die Primärwicklung 1 Windung aufweist. Eine große Windungszahl führt jedoch meistens zu einer unerwünscht großen Wickelkapazität, wodurch die Genauigkeit des Meßwandlers leidet. Strommeßwandler sind empfindlich gegen Gleichstrom. Wegen der hohen Anfangspermeabilität des Magnetkernmaterials erzeugt bereits eine kleine Gleichstromkomponente eine große Induktion, die den Kern in die Sättigung treiben kann. Dadurch entstehen unannehmbare Übertragungsfehler. Um eine geringere Gleichstromempfindlichkeit zu erreichen, kann die Strommessung auch mittels ohmscher Stromteiler (Shunts) erfolgen. Bei genauer Messung stören jedoch mögliche Temperaturdifferenzen in den einzelnen Strompfaden sowie der induktive Anteil der Widerstände.

Ferner ist ein Stromwandler mit zwei Eisenkernen bekannt (DE-A-708 667), deren Primär- und Sekundärwicklungen je hintereinandergeschaltet sind und bei dem der Kern mit der höheren Sekundärwindungszahl einen kleineren Eisenquerschnitt oder eine höhere Anfangspermeabilität aufweist, so daß beide Kerne praktisch gleichzeitig im Punkte höchster Permeabilität arbeiten.

Darüber hinaus ist es auch schon seit langem aus beispielsweise der CH-A-414 841 bekannt, Meßwandler, welche zwei Magnetkerne und Primärwicklungen sowie Sekundärwicklungen aufweisen, dadurch im optimalen Vormagnetisierungsbereich zu betreiben, daß die Kerne mit einer Kompensationswicklung entsprechend bemessener Windungszahl ausgerüstet werden.

Der Erfindung liegt die Aufgabe zugrunde, einen Meßwandler zur Messung von Wechselströmen unabhängig vom überlagerten Gleichstromanteil zu schaffen, welcher mit einer herabgesetzten Gesamtsahl der Windungen auskommt.

Die Erfindung ist im Anspruch 1 gekennzeichnet, und in Unteransprüchen sind weitere Ausbildungen beansprucht.

Ein Ausführungsbeispiel des Messwandlers nach der Erfindung wird anhand der Zeichnung näher erläutert.

Es zeigen :

Figur 1   eine prinzipielle Konstruktion des Messwandlers in perspektivischer Sicht,

Figur 2   ein elektrisches Schema des Messwandlers mit galvanischer Kopplung, und

Figur 3   ein elektrisches Schema des Messwandlers mit galvanischer Trennung.

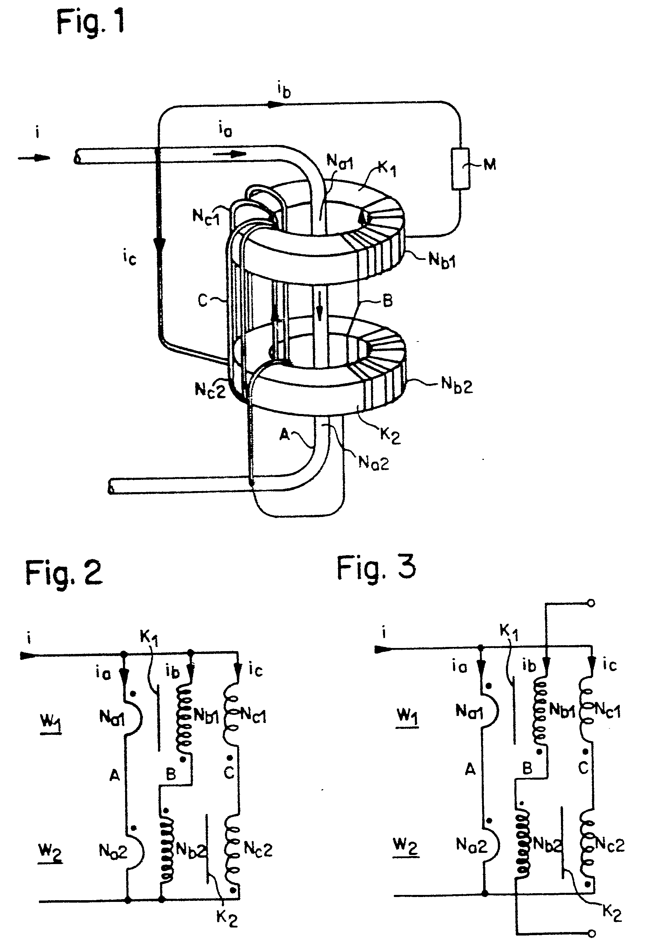

Die Fig. 1 zeigt schematisch den Aufbau des erfindungsgemässen Messwandlers, welcher im wesentlichen aus einem aus zwei Ringkernen $K_1$, $K_2$ gebildeten Magnetkern und aus drei elektrisch parallel geschalteten induktiven Stromteilern mit Strompfaden A, B, C besteht. Die Ringkerne $K_1$, $K_2$ können durch lamellierte Kerne oder durch Ferritkerne ersetzt werden.

Der erste Strompfad A durchsetzt die beiden Ringkerne $K_1$, $K_2$ und bildet aus einer einzigen Windung bestehende Wicklungen $N_{a1}$, $N_{a2}$. Der zweite Strompfad B weist zwei Wicklungen $N_{b1}$, $N_{b2}$ mit je neun Windungen auf, von denen die erste Wicklung $N_{b1}$ auf dem ersten Ringkern $K_1$ gegensinnig zur ersten Wicklung $N_{a1}$ des ersten Strompfades A und die zweite Wicklung $N_{b2}$ auf dem zweiten Ringkern im gleichen Sinn wie die zweite Wicklung $N_{a2}$ des ersten Strompfades A gewickelt ist. Der dritte Strompfad C weist Wicklungen $N_{c1}$ und $N_{c2}$ mit je vier Windungen auf, die gemeinsam über beide Ringkerne $K_1$, $K_2$ gewickelt sind, wobei die zweite Wicklung $N_{c2}$ eine zusätzliche um den zweiten Ringkern $K_2$ gelegte Windung besitzt. Es ist aber auch möglich, die erste Wicklung $N_{c1}$ um den ersten Kern $K_1$ und die zweite Wicklung $N_{c2}$ um den zweiten Kern $K_2$ zu wickeln. Die Wicklungen $N_{c1}/N_{c2}$ des Strompfades C verlaufen im Gegensinn zu den Wicklungen $N_{a1}/N_{a2}$ des ersten Strompfades A. Im Stromkreis des Strompfades B liegt ein Ankopplungsglied M für ein Messgerät.

Der zu messende Strom i wird gemäss der Fig. 2 in drei Teilströme $i_a$, $i_b$ und $i_c$ unterteilt, die im ersten Strompfad A, im zweiten Strompfad B bzw. im dritten Strompfad C fliessen. Die ersten Wicklungen $N_{a1}$, $N_{b1}$ und $N_{c1}$ dieser Strompfade bilden mit dem ersten Ringkern $K_1$ einen ersten Wandler $W_1$, die zweiten Wicklungen $N_{a2}$, $N_{b2}$ und $N_{c2}$ dieser Strompfade mit dem zweiten Ringkern $K_2$ einen zweiten Wandler $W_2$. Die Wandler $W_1$ und $W_2$ bringen die Magnetflüsse ins Gleichgewicht. Die Durchflutung der Wicklung $N_{a1}$ hebt dabei die Durchflutungen der Wicklungen $N_{b1}$ und $N_{c1}$ wegen des entgegengesetzten Wicklungssinns auf. In analoger Weise werden die Durchflutungen der Wicklungen $N_{a2}$ und $N_{b2}$ durch die Durchflutung der Wicklungen $N_{c2}$ aufgehoben.

Es gilt somit :

$$i_a \cdot N_{a1} = i_b \cdot N_{b1} + i_c \cdot N_{c1} \text{ und} \tag{1}$$

$$i_c \cdot N_{c2} = i_a \cdot N_{a2} + i_b \cdot N_{b2} \tag{2}$$

2

Unter Verwendung der entsprechenden Windungszahlen ist danach

$$i_c = 18\, i_b \qquad\qquad (3)$$

$$i_a = 81\, i_b \qquad\qquad (4)$$

Das Uebersetzungsverhältnis ist bekanntlich

$$\ddot{u}_b = \frac{i}{i_b} = \frac{i_a + i_b + i_c}{i_b}, \qquad\qquad (5)$$

was nach dem Einsetzen der oben angeführten Resultate (3) und (4) eine Uebersetzung von 100 ergibt. Es ist somit möglich mit Hilfe von insgesamt 29 Windungen des Messwandlers dieselbe Uebersetzung von 100 zu erzielen, für welche 100 Windungen sekundärseitig bei einer einzigen primärseitigen Windung erforderlich wären. Diese bedeutende Ersparnis an Windungen und somit an Windungsdraht hat eine Herabsetzung der Wicklungskapazitäten und der Herstellungskosten zur Folge. Die Teilung des Stromes wird lediglich durch die Windungszahlen bewirkt, die die gewünschte Uebersetzung bestimmen.

Analog dem Verhalten des Messwandlers unter Wechselstrom müssen sich die Durchflutungen bei Gleichstrom bei den beiden Wandlern $W_1$ und $W_2$ aufheben. Diese Aufhebung wird aber nur dann erreicht, wenn das Verhältnis der Widerstände der einzelnen Strompfade A, B, C dem Verhältnis der Uebersetzungen dieser Strompfade A, B, C entspricht. Es muss somit gelten :

$$R_a : R_c : R_b = \ddot{u}_a : \ddot{u}_c : \ddot{u}_b \,.$$

Bei Wechselstrom sowie bei Gleichstrom sind die beiden Wandler $W_1$, $W_2$ fast im Gleichgewicht. Der kompensierende Strom $i_b$ ist somit bei kleinen Windungszahlen $N_{b1}$, $N_{b2}$ klein, so dass er sogar galvanisch getrennt werden kann. Ein entsprechendes elektrisches Schema für beide Wandler $W_1$, $W_2$ mit einem von den Strompfaden A und C getrennten Strompfad B ist aus der Fig. 3 ersichtlich. Ein solcher Messwandler hat den Vorteil, dass ein in den meisten Fällen erforderlicher, zur galvanischen Trennung dienender Zwischenwandler im Strompfad B vermieden werden kann. Die Stromsumme i besteht jedoch aus den Teilströmen $i_a$ und $i_c$, so dass das Uebersetzungsverhältnis

$$\ddot{u}_b = \frac{i_a + i_c}{i_b}$$

beträgt. Nach dem Einsetzen der Werte in die Formeln (3) und (4) macht die Uebersetzung beim beschriebenen Messwandler lediglich 99 aus. Um auch hier eine Uebersetzung von 100 zu erreichen, müssen die Windungszahlen der Wicklungen $N_{b1}$ und $N_{b2}$ des abgetrennten Strompfades B 10 bzw. 8 Windungen aufweisen, was sich anhand der Formeln (1) und (2) leicht nachrechnen lässt.

Die Stromteilung bei Wechselstrom wird durch die Windungszahlen der einzelnen Wicklungen bestimmt und unterliefgt damit weder dem Einfluss der Temperatur noch dem Einfluss der Widerstände der Wicklungen. Die Stromunterteilung bei vorhandenem Gleichstromanteil wird im wesentlichen durch die ohmschen Widerstände der Strompfade A, B und C bestimmt. Die vorgeschlagene Parallelschaltung aller drei bzw. zwei Strompfade A und C erlaubt kleine Windungszahlen auch bei grosser Stromunterteilung und ergibt dadurch kleine Wicklungskapazitäten.

Durch die Aenderung von Windungszahlen der einzelnen Wicklungen kann das Uebersetzungsverhältnis und somit die Unterteilung des zu messenden Stromes in weiten Grenzen geändert werden. Die Bestückung der beiden Wandler $W_1$ und $W_2$ muss aber so erfolgen, dass die Strompfade fast im Gleichgewicht sind und dass sich die Durchflutungen aufheben.

**Patentansprüche**

1. Meßwandleranordnung mit zwei Magnetkernen ($K_1$, $K_2$) zur Messung von elektrischen Wechselströmen mit Primär- und Sekundärkreis aus jeweils hintereinandergeschalteten Wicklungen (N) mit zum Teil unterschiedlichen Windungszahlen, welche Wicklungen mit beiden Kernen je einen ersten und einen zweiten Wandler ($W_1$, $W_2$) bilden, dadurch gekennzeichnet, daß zur Messung der elektrischen Wechselströme unabhängig von einem überlagerten Gleichstromanteil der Primärkreis durch einen ersten und einen zweiten Primärkreis (A, C) gebildet ist und mindestens die beiden Primärkreise (A, C) parallel geschaltet und derart gegensinnig gewickelt sind, daß sich die Durchflutungen im wesentlichen aufheben.

2. Meßwandleranordnung nach Anspruch 1, dadurch gekennzeichnet, daß in den Primär- und Sekundärkreisen (A, B, C) das Verhältnis derer ohmscher Widerstände ($R_a : R_b : R_c$) dem Verhältnis derer Übersetzungen ($\ddot{U}_a : \ddot{U}_b : \ddot{U}_c$) im wesentlichen entspricht.

3. Meßwandleranordnung nach Anspruch 1 oder 2, dadurch gekennzeichnet, daß die Wicklungen

($N_{a1}$, $N_{a2}$) des ersten Primärkreises (A) gleichsinnig auf beiden Kernen ($K_1$, $K_2$), die erste Wicklung ($N_{b1}$) des Sekundärkreises (B) auf dem ersten Kern ($K_1$) gegensinnig zu der ersten Wicklung ($N_{a1}$) des ersten Primärkreises (A) und die zweite Wicklung ($N_{b2}$) des Sekundärkreises (B) auf dem zweiten Kern ($K_2$) gleichsinnig zu der zweiten Wicklung ($N_{a2}$) des ersten Primärkreises (A) und die Wicklungen ($N_{c1}$, $N_{c2}$) des zweiten Primärkreises (C) auf den beiden Kernen ($K_1$, $K_2$) gegensinnig zu den Wicklungen ($N_{a1}$, $N_{a2}$) des ersten Primärkreises (A) gewickelt sind, und daß die zweite Wicklung ($N_{c2}$) des zweiten Primärkreises (C) eine weitere Windung auf dem zweiten Kern ($K_2$) besitzt.

4. Meßwandleranordnung nach einem der vorhergehenden Ansprüche, dadurch gekennzeichnet, daß auch der Sekundärkreis (B) parallel zu den beiden Primärkreisen (A, C) geschaltet ist.

5. Meßwandleranordnung nach einem der vorhergehenden Ansprüche, dadurch gekennzeichnet, daß die Kerne ($K_1$, $K_2$) als Ringkerne ausgebildet sind.

6. Meßwandleranordnung nach Anspruch 5, dadurch gekennzeichnet, daß die Kerne ($K_1$, $K_2$) Ferritkerne sind.

## Claims

1. A measuring transformer arrangement comprising two magnetic cores ($K_1$, $K_2$) for measuring electrical alternating currents having primary and secondary circuits respectively comprising windings (N) which are connected in succession, with partly different numbers of turns, which windings with the two cores respectively form first and second transformers ($W_1$, $W_2$), characterised in that for the purposes of measuring the electrical alternating currents independently of a superimposed direct current component the primary circuit is formed by first and second primary circuits (A, C) and at least the two primary circuits (A, C) are connected in parallel and are wound in opposite directions in such a way that the magnetomotive forces substantially cancel each other.

2. A measuring transformer arrangement according to claim 1 characterised in that in the primary and secondary circuits (A, B, C) the relationship of the ohmic resistances ($R_a$ : $R_b$ : $R_c$) thereof substantially corresponds to the relationship of the transformation ratios ($\ddot{U}_a$ : $\ddot{U}_b$ : $\ddot{U}_c$) thereof.

3. A measuring transformer arrangement according to claim 1 characterised in that the windings ($N_{a1}$, $N_{a2}$) of the first primary circuit (A) are wound in the same direction on both cores ($K_1$, $K_2$), the first winding ($N_{b1}$) of the secondary circuit (B) on the first core ($K_1$) is wound in the opposite direction to the first winding ($N_{a1}$) of the first primary circuit (A) and the second winding ($N_{b2}$) of the secondary circuit (B) on the second core ($K_2$) is wound in the same direction in relation to the second winding ($N_{a2}$) of the first primary circuit (A) and the windings ($N_{c1}$, $N_{c2}$) of the second primary circuit (C) on the two cores ($K_1$, $K_2$) are wound in the opposite direction to the windings ($N_{a1}$, $N_{a2}$) of the first primary circuit (A), and that the second winding ($N_{c2}$) of the second primary circuit (C) has a further turn on the second core ($K_2$).

4. A measuring transformer arrangement according to one of the preceding claims characterised in that the secondary circuit (B) is also connected in parallel to the two primary circuits (A, C).

5. A measuring transformer arrangement according to one of the preceding claims characterised in that the cores ($K_1$, $K_2$) are formed as annular cores.

6. A measuring transformer arrangement according to claim 5 characterised in that the cores ($K_1$, $K_2$) are ferrite cores.

## Revendications

1. Montage de transformateurs d'intensité avec deux noyaux magnétiques ($K_1$, $K_2$) pour mesurer des courants électriques alternatifs à l'aide d'un circuit primaire et d'un circuit secondaire constitués chacun de bobinages (N) montés en série ayant en partie des nombres de spires différents, lesquels bobinages constituent avec les deux noyaux respectivement un premier et un deuxième transformateur ($W_1$, $W_2$), caractérisé par le fait qu'en vue de mesurer des courants électriques alternatifs indépendamment d'une composante de courant continu superposée, le circuit primaire est formé par un premier et un deuxième circuit primaire (A, C), et qu'au moins les deux circuits primaires (A, C) sont montés en parallèle et bobinés en sens opposés de sorte que les flux magnétiques sont pour l'essentiel annulés.

2. Montage de transformateurs d'intensité selon la revendication 1, caractérisé par le fait que dans les circuits primaires et secondaires (A, B, C), le rapport des résistances ohmiques ($R_a$ : $R_b$ : $R_c$) des circuits est sensiblement égal au rapport des transformations ($\ddot{u}_a$ : $\ddot{u}_b$ : $\ddot{u}_c$) des circuits.

3. Montage de transformateurs d'intensité selon la revendication 1 ou 2, caractérisé par le fait que les bobinages ($N_{a1}$, $N_{a2}$) du premier circuit primaire (A) sont bobinés dans le même sens sur les deux noyaux ($K_1$, $K_2$), que le premier bobinage ($N_{b1}$) du circuit secondaire (B) est bobiné sur le premier noyau ($K_1$) en sens opposé du premier bobinage ($N_{a1}$) du premier circuit primaire (A), que le deuxième bobinage ($N_{b2}$) du circuit secondaire (B) est bobiné sur le deuxième noyau ($K_2$) dans le sens du deuxième bobinage ($N_{a2}$) du premier circuit primaire (A), que les bobinages ($N_{c1}$, $N_{c2}$) du deuxième circuit primaire (C) sont bobinés sur les deux noyaux ($K_1$, $K_2$) en sens opposé des bobinages ($N_{a1}$, $N_{a2}$) du premier circuit primaire (A), et que le deuxième bobinage ($N_{c2}$) du deuxième circuit primaire (C) présente une spire supplémentaire sur le deuxième noyau ($K_2$).

4. Montage de transformateurs d'intensité selon l'une quelconque des revendications précédentes, caractérisé par le fait que le circuit secondaire (B) est lui aussi monté en parallèle avec les deux circuits primaires (A, C).

5. Montage de transformateurs d'intensité selon l'une quelconque des revendications précédentes, caractérisé par le fait que les noyaux ($K_1$, $K_2$) sont réalisés sous la forme de noyaux toroïdaux.

6. Montage de transformateurs d'intensité selon la revendication 5, caractérisé par le fait que les noyaux ($K_1$, $K_2$) sont des noyaux en ferrite.

# Fig. 1

# Fig. 2

# Fig. 3